Europäisches Patentamt

**European Patent Office**

Office européen des brevets

(19)

(11) Publication number: **0 347 471**
**A1**

# EUROPEAN PATENT APPLICATION

(12)

published in accordance with Art. 158(3) EPC

(21) Application number: **89900913.8**

(22) Date of filing: **26.12.88**

Data of the international application taken as a basis:

(86) International application number:
**PCT/JP88/01330**

(87) International publication number:
**WO89/06439 (13.07.89 89/15)**

(51) Int. Cl.³: **H 01 L 21/66**
**H 03 K 17/78**

(30) Priority: **28.12.87 JP 334937/87**

(43) Date of publication of application:
**27.12.89 Bulletin 89/52**

(84) Designated Contracting States:
**CH DE FR GB IT LI NL**

(71) Applicant: **KANEGAFUCHI KAGAKU KOGYO KABUSHIKI KAISHA**
**2-4 Nakanoshima 3-chome**
**Kita-ku Osaka-shi Osaka 530(JP)**

(72) Inventor: **MURAKAMI, Satoru**
**6-6-522, Maikodai Tarumi-ku**
**Kobe-shi Hyogo 655(JP)**

(72) Inventor: **YOSHIDA, Eiichi**
**1-2-33, Yoshida-cho Hyogo-ku**
**Kobe-shi Yogo 652(JP)**

(72) Inventor: **ZENKI, Tomoyoshi**
**6-31-17, Shioya-cho Tarumi-ku**
**Kobe-shi Hyogo 655(JP)**

(72) Inventor: **YAMAGUCHI, Minori**
**5-40, Higashihitomaru-cho**
**Akashi-shi Hyogo 673(JP)**

(72) Inventor: **NAKAYAMA, Takehisa**
**2-9-30, Maikodai Tarumi-ku**
**Kobe-shi Hyogo 655(JP)**

(72) Inventor: **TAWADA, Yoshihisa**
**14-39, Oikemiyamadai Kita-ku**
**Kobe-shi Hyogo 651-12(JP)**

(74) Representative: **Vossius & Partner**
**Siebertstrasse 4 P.O. Box 86 07 67**
**D-8000 München 86(DE)**

(54) **SOLAR CELL ARRAY FOR DRIVING MOSFET GATES.**

(57) A solar cell array for producing electromotive force in response to incident light to drive MOSFET gates for use as a semiconductor relay. The manufacture of a crystalline silicon semiconductor used as a solar cell for the semiconductor relay requires too many mask patterns and complicated processes. This involves difficulties in device integration and thin-film formation, resulting in an increase in the cost. The invention provides a solar cell wherein a great number of semiconductor cells of amorphous silicon are connected in series to drive MOSFET gates.

S P E C I F I C A T I O N

-

TITLE OF THE INVENTION

    Solar Cell Array for Driving MOSFET Gates


TECHNICAL FIELD

    The present invention relates to a MOSFET gate driving solar cell array used in a semiconductor relay for driving a MOSFET by inputting an electromotive force generated by a solar cell upon reception of an optical beam to the gate of the MOSFET.


BACKGROUND TECHNIQUE

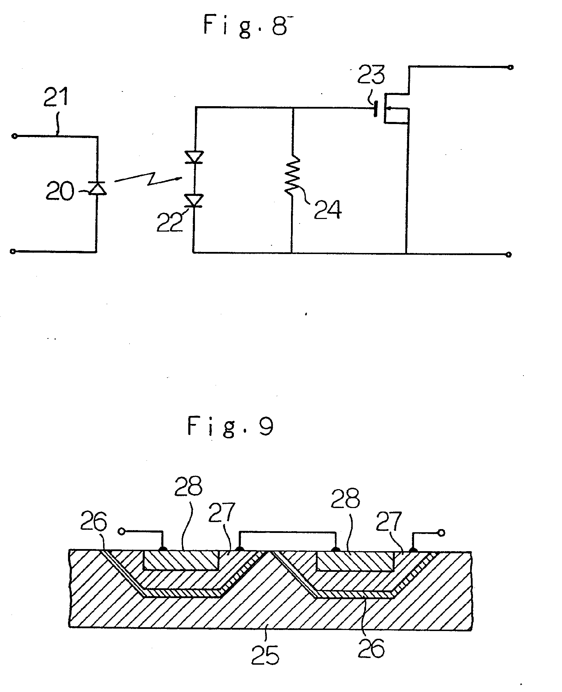

    In the prior art, there exists a semiconductor relay making use of a MOSFET, which has its fundamental structure shown in a simplified circuit diagram in Fig. 8.

    Designated at reference numeral 20 is a light emitting diode (which will be shortly referred to as the "LED") for emitting a light when supplied with a control current by a control circuit 21. Numeral 22 designates solar cells for generating an output voltage upon reception of the light of the LED 20.

    The output voltage of the solar cells 22 is supplied to the gate of a MOSFET 23 so that the MOSFET 23 has its source and drain turned on or off.

Incidentally, reference numeral 24 designates a discharge resistor.

The solar cells 22 used here have such a structure as is shown in section in Fig. 9.

Over a poly- or single-crystalline silicon semiconductor substrate 25, there are formed oxide insulating films 26 to make individual cells independent. Each cell is constructed by laying a single- or polycrystalline p-type silicon semiconductor layers 27 and n-type silicon semiconductor layers 28 over the oxide insulating film 26, and the adjoining cells are connected in series.

In the solar cells used in such semiconductor relay, the oxide insulating film 26 has to be formed to separate the cells because it is made of the crystalline silicon substrate, and has to be formed with the semiconductor layers by using a number of mask patterns. As a result, the solar cells are accompanied by a problem that their fabrication process is so complicated that it is difficult to accomplish their integration and to form them in a thin film form and that their fabrication cost is high.

DISCLOSURE OF THE INVENTION

The present invention has been conceived in view of the above-specified problem to provide a MOSFET gate driving solar cell array to be used with a semiconductor relay including solar cells for generating an electromotive force in response to the light of a light emitting diode and a MOSFET having its gate supplied with the output voltage of said solar cells, which array comprises a multiplicity of amorphous silicon semiconductor cells connected in series.

With the above-specified structure, according to the present invention, the output voltage of the solar cell array having the multiple amorphous silicon semiconductor cells connected in series is fed to the gate of the MOSFET to construct the semiconductor relay.

BRIEF DESCRIPTION OF THE DRAWINGS

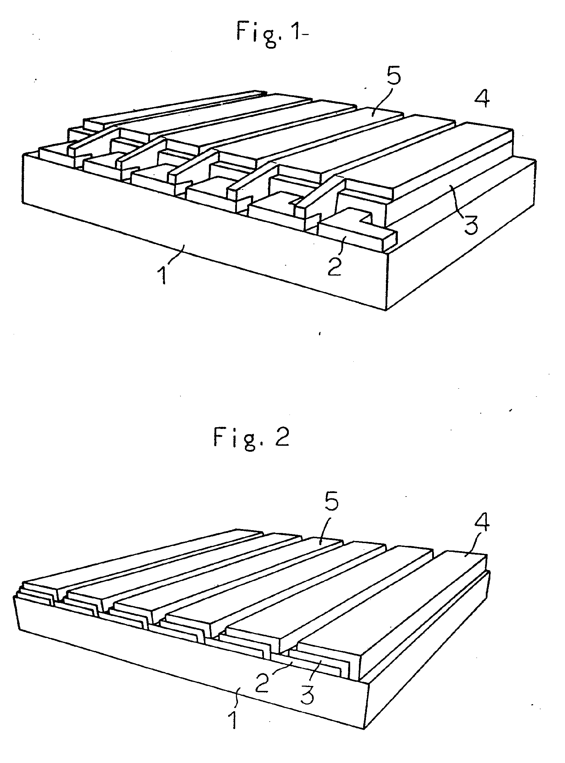

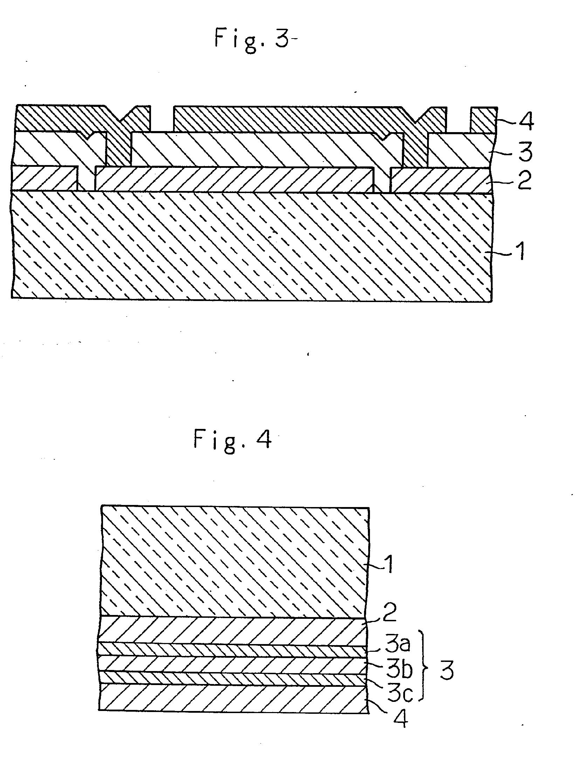

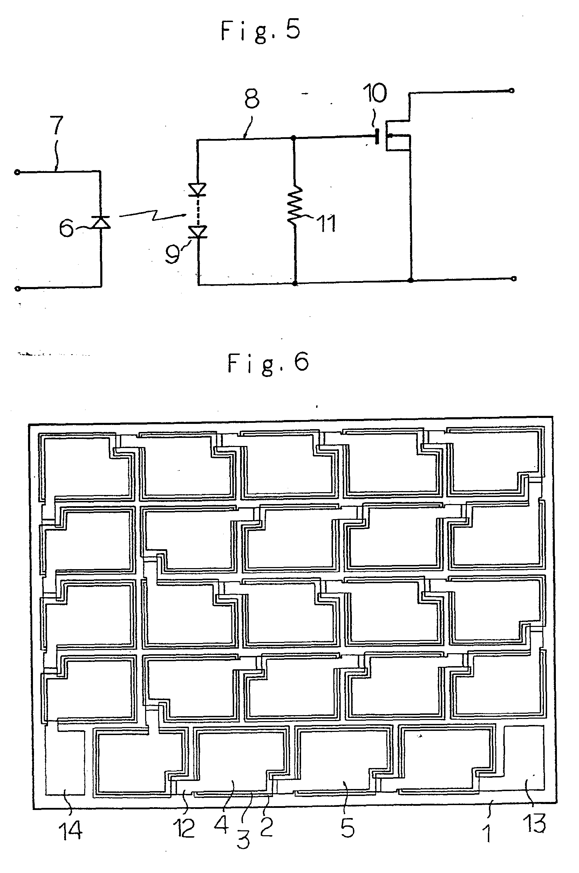

Figs. 1 and 2 are perspective views for describing a MOSFET gate driving solar cell array according to the present invention; Fig. 3 is a section for describing the MOSFET gate driving solar cell array according to the present invention; Fig. 4 is a section for describing the MOSFET gate driving solar cell array according to the present invention; Fig. 5 is a schematic circuit diagram showing a semiconductor relay using the MOSFET

- 3 -

gate driving solar cell array according to the present invention; Fig. 6 is a top plan view for describing an example for fabricating the MOSFET gate driving solar cell array according to the present invention; Fig. 7 is a section for describing an example for fabricating another MOSFET gate driving solar cell array according to the present invention; Fig. 8 is a schematic circuit diagram showing the example of the prior art; and Fig. 9 is a section for describing the example of the prior art.

BEST MODE FOR CARRYING OUT THE INVENTION

The present invention will be described in detail in the following in connection with its embodiments with reference to the accompanying drawings.

Figs. 1 and 2 are perspective views for describing solar cell arrays in general use, respectively.

Designated at reference numeral 1 is an insulating substrate, which is made of a transparent material such as glass and arranged at the light receiving side of a solar cell.

The insulating substrate 1 is sequentially overlaid by a lower electrode 2 which is made of a transparent, conductive film such as indium-tin oxide (which will be shortly referred to as the "ITO") or tin di-

oxide (i.e., $SnO_2$), an amorphous silicon semiconductor layer 3 and an upper electrode 4 made of a metal such as aluminum.

On the contrary, the insulating substrate, the upper electrode, the amorphous silicon semiconductor layer and the lower electrode may likewise be laminated on the back of the above-specified light receiving face to form a light receiving face at the opposite side of the insulating substrate.

In either of the embodiments of Figs. 1 and 2, the lower electrodes 2 and the upper electrodes of a plurality of adjoining unit cells 5 are connected in series. In the case of Fig. 1, the lower electrodes 2 and the upper electrodes 4 are led out and connected at the longitudinal leading ends of the unit cells 5. In the case of Fig. 2, those electrodes 2 and 4 are connected at the longitudinal sides of the unit cells 5.

The structure of the integrated portion of the solar cell array shown in Fig. 2, for example, is shown in Fig. 3.

Specifically, the lower electrode 2 is formed over the insulating substrate 1 disposed at the light receiving side of the solar cell array under consideration and is divided by an etching process or by means of a laser beam to form unit cells having a small area.

- 5 -

Over the lower electrodes 2, there is laid by a glow discharge decomposition process the amorphous silicon semiconductor layer 3, which is also divided into unit cells of small area like the transparent electrode 2 by means of a laser beam or the like.

Moreover, the upper electrode 4 is formed by an electron beam evaporation and is divided into unit cells by a chemical etching process.

The solar cell array can be fabricated with ease and at a low cost, because it thus uses the amorphous silicon semiconductor. The structure shown in section in Fig. 4 is used for further enhancing the energy transformation efficiency.

Specifically, there is used a PIN heterojunction type amorphous silicon semiconductor layer in which a p-type amorphous silicon carbide 3a, an i-type amorphous silicon 3b and an n-type amorphous silicon 3c are sequentially laminated from the light receiving side of the amorphous semiconductor layer 3.

The MOS type field effect transistor (which will be shortly referred to as the "MOSFET") is driven by using such solar cell array, as shown in a schematic circuit diagram in Fig. 5.

Numeral 6 designates a LED for emitting a light according to the control current of a control circuit 7.

Numeral 8 designates a relay circuit which is composed of: solar cells 9 for generating an electromotive force in response to the light of the aforementioned LED 6; and a MOSFET 10 having its gate supplied with the output voltage of the solar cells 9.

Incidentally, reference numeral 11 designates a discharge resistor.

When the control current is generated in the control circuit 7 so that the LED 6 emits a light, the solar cells 9 generate their electromotive force in response to the light. Then, the MOSFET 10 is turned on since it is supplied at its gate with the output voltage of the solar cell 9.

When the LED 6 has its light put out, a discharge is effected by the discharge resistor 11 connected in parallel with the solar cells 9 so that the MOSFET 10 is turned off.

In these ways, the MOSFET 10 is turned on or off in response to the output voltage of the solar cells 9. The gate voltage for turning on the existing MOSFET is 3 to 4 V or more. If the electromotive force of each of the solar cells made of the amorphous silicon semiconductor is 0.5 V, a voltage of 3 V is generated if six unit cells are connected in series and is accepted as sufficient for driving the gate of the MOSFET.

Fig. 6 is a top plan view for describing an example of forming the MOSFET gate driving solar cell array according to the present invention.

This example is prepared by arraying twenty four unit cells 5 in series over the insulating substrate having a size of 3 mm x 4 mm, and the lower electrode 2 and the upper electrode 4 of the adjoining unit cells are connected in series with each other at an electrode connecting portion 12.

At the unit cells positioned at the two ends of the series connection, there are prepared a lower electrode lead-out portion 13 and an upper electrode lead-out portion 14 for providing the overall electrode portions.

In case the circuit shown in Fig. 5 was constructed by making use of the solar cell array described above, in case the LED 6 emitted a light of 0.5 mW/cm and in case the discharge resistor 11 connected had a resistance of 1 Mega Ohms, the solar cells 9 generated an output voltage of 10 V or higher so that the MOSFET 10 operated to a remarkably excellent manner.

The shown example was exemplified by connecting the twenty four unit cells in series. The array over the insulating substrate is arbitrary. If, moreover, at least six steps are included in the series connection, the MOSFET 10 can operate to a satisfactory extent. Therefore, the number of steps should not be limited to six but can be arbitrarily selected.

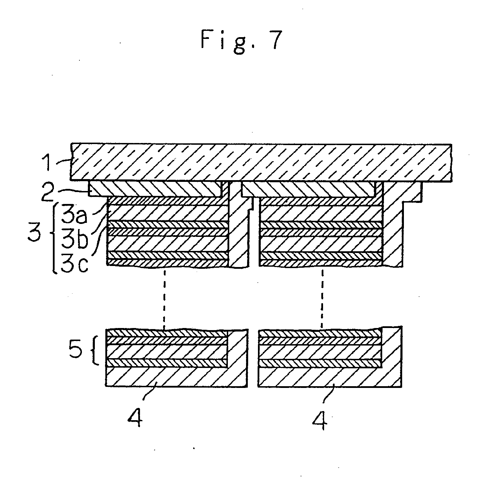

Fig. 7 is a section for describing another embodiment of the MOSFET gate driving solar cell array according to the present invention.

Over an insulating substrate 1 made of a transparent material such as glass and arranged at the light receiving side, there is formed a lower electrode 2 which is made of a transparent, conductive film of the ITO or $SnO_2$.

There is further overlaid amorphous silicon semiconductor layers 3a, 3b and 3c which in turn form a unit cell 5. The amorphous silicon semiconductor layers to be used here is constructed, as shown in Fig. 4, of a PIN heterojunction type amorphous silicon semiconductor layer which is formed by laminating the p-type amorphous silicon carbide 3a, the i-type amorphous silicon 3b and the n-type amorphous silicon 3c from the light receiving face.

The amorphous silicon semiconductor layer 3 is overlaid by a similar amorphous silicon semiconductor layer 3 such that twelve unit cells 5 are connected in series.

0347471

Over the back of the light receiving face of the twelve amorphous silicon semiconductor layers 3 connected in series, there are formed upper electrodes 4 which are made of a metal such as aluminum so that the electromotive force of the twelve series amorphous silicon semiconductor layers 3 may be led out therethrough.

In the shown embodiment, two sets of twelve unit cells 5 connected in series are connected so that they may generate an output voltage as high as that generated by the structure of Fig. 6 having the twenty four unit cells connected in series.

The MOSFET gate driving solar cell array shown in Fig. 7 can be small-sized because it can generate a similar power with a smaller area than that of Fig. 6.

INDUSTRIAL APPLICABILITY

According to the present invention, the MOSFET gate driving solar cell array has the structure thus far described and uses the amorphous silicon semiconductor layer so that it can be fabricated without difficulty and provided at a low cost.

The solar cell array thus fabricated can be easily integrated and connected in series at multiple steps and can supply the gate voltage of the MOSFET.

- 11 -

Thanks to the use of the amorphous silicon semiconductor layer, moreover, the laminated structure can be made thin so that the semiconductor relay to be assembled with the solar cell array of the present invention can be small-sized.

SCOPE OF THE CLAIM

1)   A MOSFET gate driving solar cell array to be used with a semiconductor relay including solar cells for generating an electromotive force in response to the light of a light emitting diode and a MOSFET having its gate supplied with the output voltage of said solar cell, which array comprises a multiplicity of amorphous silicon semiconductor cells connected in series.

2)   A MOSFET gate driving solar cell array according to Claim 1, wherein said amorphous silicon semiconductor cells are connected in series at at least six steps.

3)   A MOSFET gate driving solar cell array according to Claim 1 or 2, wherein said amorphous silicon semiconductor cells are constructed of a heterojunction containing an amorphous silicon carbide layer.

0347471

Fig. 1-

5

4

3

2

1

Fig. 2

5

4

2

3

1

0347471

Fig. 3

Fig. 4

Fig. 5

Fig. 6

Fig. 7

Fig. 8

Fig. 9

# INTERNATIONAL SEARCH REPORT

International Application No PCT/JP88/01330

## I. CLASSIFICATION OF SUBJECT MATTER (if several classification symbols apply, indicate all) 6

According to International Patent Classification (IPC) or to both National Classification and IPC

Int.Cl$^4$  H01L21/66, H03K17/78

## II. FIELDS SEARCHED

### Minimum Documentation Searched 7

| Classification System | Classification Symbols |
|---|---|
| IPC | H01L21/66, H03K17/78 |

### Documentation Searched other than Minimum Documentation to the Extent that such Documents are Included in the Fields Searched 8

| | |
|---|---|
| Jitsuyo Shinan Koho | 1971 – 1988 |
| Kokai Jitsuyo Shinan Koho | 1971 – 1988 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, U, 48-41281 (Toho Denki Kogyo Kabushiki Kaisha) 25 May 1973 (25. 05. 73) (Family: none) | 1-3 |
| Y | Tachikawa Iwao (FET no tsukaikata) 1 June 1975 (01. 06. 75) CQ Shuppansha (Tokyo) Page 101, lines 7 to 8 | 1-3 |
| Y | JP, A, 56-152278 (Sanyo Electric Co., Ltd.) 25 November 1981 (25. 11. 81) Figs. 1 to 4 (Family: none) | 2 |
| Y | JP, A, 58-115872 (Kanegafuchi Chemical Industry Co., Ltd.) 9 July 1983 (09. 07. 83) Page 3, lower left column, line 17 to page 3, lower right column, line 5 & EP, A2, 78541 | 3 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| March 13, 1989 (13. 03. 89) | April 10, 1989 (10. 04. 89) |

| International Searching Authority | Signature of Authorized Officer |
|---|---|
| Japanese Patent Office | |

FURTHER INFORMATION CONTINUED FROM THE SECOND SHEET

| X | Nikkei Electronics, No.414, 2 September 1987 (Tokyo) NE Report P106-107 (Figs. 1, 2, 3, see, P.107, column 2, lines 3 to 5) | 1-3 |
|---|---|---|

**V.☐ OBSERVATIONS WHERE CERTAIN CLAIMS WERE FOUND UNSEARCHABLE [1]**

This international search report has not been established in respect of certain claims under Article 17(2) (a) for the following reasons:

1.☐ Claim numbers .........., because they relate to subject matter not required to be searched by this Authority, namely:

2.☐ Claim numbers .........., because they relate to parts of the international application that do not comply with the prescribed requirements to such an extent that no meaningful international search can be carried out, specifically:

3.☐ Claim numbers .........., because they are dependent claims and are not drafted in accordance with the second and third sentences of PCT Rule 6.4(a).

**VI.☐ OBSERVATIONS WHERE UNITY OF INVENTION IS LACKING [2]**

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)